(19) 

**Europäisches Patentamt**
**European Patent Office**
**Office européen des brevets**

(11) **EP 4 718 095 A1**

(12) **EUROPEAN PATENT APPLICATION**
published in accordance with Art. 153(4) EPC

(43) Date of publication:
**01.04.2026 Bulletin 2026/14**

(21) Application number: **24869671.8**

(22) Date of filing: **16.04.2024**

(51) International Patent Classification (IPC):
*G01R 31/382* (2019.01)    *G01R 31/387* (2019.01)
*G01R 31/367* (2019.01)

(52) Cooperative Patent Classification (CPC):
**G01R 31/367; G01R 31/382; G01R 31/387**

(86) International application number:
**PCT/CN2024/088005**

(87) International publication number:
**WO 2025/066102 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.09.2023 CN 202311256358**

(71) Applicants:
• **Sineng Electric Co., Ltd.**
  **Wuxi, Jiangsu 214174 (CN)**

• **Suzhou Qiancheng New Energy Technology Co., Ltd.**
  **Suzhou, Jiangsu 215101 (CN)**

(72) Inventor: **ZHANG, He**
  **Wuxi, Jiangsu 214174 (CN)**

(74) Representative: **Bayramoglu et al.**
  **Mira Office**
  **Kanuni Sultan Süleyman Boulevard 5387**
  **Street Beytepe, floor 12, no:50**
  **06800 Cankaya, Ankara (TR)**

(54) **BATTERY SOC ESTIMATION METHOD AND APPARATUS WITH END CORRECTION**

(57)    This application discloses a battery SOC estimation method and apparatus with terminal correction. The method includes: step (1): obtaining an initial value $SOC_0$ of a battery capacity based on an open-circuit voltage method when the battery pack does not operate and is in a resting state; step (2): updating in real time, during operating of the battery pack, a SOC of the battery pack based on preset correction factors affecting the battery capacity, where the correction factors include a charge/discharge current correction factor, a temperature correction factor, and a charge/discharge cycle quantity correction factor; step (3): when the battery pack stops operating, correcting the initial value $SOC_0$ of the battery capacity based on the open-circuit voltage method and the SOC before the battery pack stops operating; and step (4): performing terminal correction on the SOC if the SOC of the battery pack is greater than 90% or less than 10%. This application can improve accuracy and stability of battery SOC estimation.

FIG. 1

## Description

This application claims priority to Chinese Patent Application No. 202311256358.6, filed with the China National Intellectual Property Administration on September 26, 2023 and entitled "BATTERY SOC ESTIMATION METHOD AND APPARATUS WITH TERMINAL CORRECTION", which is incorporated herein by reference in its entirety.

## TECHNICAL FIELD

This application relates to the field of power management technologies of energy storage batteries, and in particular, to a battery SOC estimation method and apparatus with terminal correction, a storage medium, and a computer device.

## BACKGROUND

To address the global energy crisis and reduce carbon emissions, many countries have optimized the management and operation of energy storage systems to enhance system performance and efficiency thereof. In the household energy storage field, state of charge (SOC) estimation of batteries is particularly critical. Precisely estimating SOC may enable rational arrangement of charge/discharge strategies, better balancing of energy supply and demand, and prolonging of service lives of the batteries. In addition, users may be provided with accurate information about available battery energy, allowing the users to properly schedule energy usage as required, and improving user experience.

Currently, a SOC estimation method in the mainstream market has low estimation precision and poor real-time performance.

## SUMMARY

This application provides a battery SOC estimation method and apparatus with terminal correction, a storage medium, and a computer device, to improve accuracy and stability of battery SOC estimation.

According to an aspect of this application, a battery SOC estimation method with terminal correction is provided, including the following steps:

step (1): obtaining an initial value $SOC_0$ of a battery capacity based on an open-circuit voltage method when the battery pack does not operate and is in a resting state;

step (2): updating in real time, during operating of the battery pack, a SOC of the battery pack based on preset correction factors affecting the battery capacity, where the correction factors include a charge/discharge current correction factor, a temperature correction factor, and a charge/discharge cycle quantity correction factor;

step (3): when the battery pack stops operating, correcting the initial value $SOC_0$ of the battery capacity based on the open-circuit voltage method and the SOC before the battery pack stops operating; and

step (4): performing terminal correction on the SOC if the SOC of the battery pack is greater than 90% or less than 10%.

Optionally, step (1) includes:

obtain a correspondence diagram of an open-circuit voltage and the SOC of the battery pack that is determined in a curve fitting manner; and

obtaining the open-circuit voltage of the battery pack based on the open-circuit voltage method, and determining, based on the correspondence diagram, the initial value $SOC_0$ of the battery capacity that corresponds to the open-circuit voltage of the battery pack, where

the correspondence diagram of the open-circuit voltage and the SOC of the battery pack is plotted by performing the following steps:

discharging the battery pack to a cut-off voltage at a constant current, and resting the battery pack until the battery pack is completely discharged;

charging the completely discharged battery pack at a constant current to 5% of a rated capacity, recording a terminal voltage of the battery pack in this case, and resting the battery pack for preset duration;

continuing to charge the battery pack at a constant current to 10% of the rated capacity, recording a terminal voltage of the battery pack in this case, and resting the battery pack for preset duration; and

continuing to charge the battery pack at a constant current until the battery pack is fully charged, and plotting the correspondence diagram of the open-circuit voltage and the SOC of the battery pack in the curve fitting manner after the battery pack is fully charged, where 5% of the rated capacity is charged each time.

Optionally, the method further includes:
obtaining the initial value $SOC_0$ of the battery capacity based on the open-circuit voltage method again and updating the initial value $SOC_0$ when a resting time of the battery pack exceeds a specific value.

Optionally, a calculation formula for updating the SOC in step (2) is:

$$SOC = SOC_0 - K_n \frac{1}{C} \eta K_t \int_0^t K_i i \, dt$$

where $SOC_0$ is an initial state of charge of the battery pack, C is a total capacity of the battery pack, $\eta$ is charge/discharge efficiency of the battery pack, i is a charge/discharge current, $K_n$ is the charge/discharge cycle quantity correction factor, $K_t$ is the temperature correction factor, and $K_i$ is the charge/discharge current correction factor.

Optionally, the charge/discharge current correction factor in step (2) is determined based on a function relationship between the charge/discharge current correction factor and a discharge current, and the function relationship between the charge/discharge current correction factor and the discharge current is obtained by performing the following steps:

charging the battery pack to a fully charged state in a normal temperature environment of 25°C;
discharging the fully charged battery pack at a constant current, and recording a battery discharge capacity in this case;
changing the discharge current with a temperature remaining unchanged to discharge the fully charged battery pack, and recording a battery discharge capacity in this case; and
repeating the foregoing steps to obtain a relationship between the discharge current and an actual discharge capacity, and performing curve fitting by using MATLAB based on the relationship between the discharge current and the actual discharge capacity to obtain a function relationship between a discharge current correction factor and the discharge current.

Optionally, the temperature correction factor in step (2) is determined based on a function relationship between a temperature and the temperature correction factor, and the function relationship between the temperature and the temperature correction factor is obtained by performing the following steps:

setting a constant temperature chamber to -20°C, charging the battery pack to a fully charged state, placing the battery pack in the constant temperature chamber, resting the battery pack until a temperature of the battery pack is consistent with a temperature of the constant temperature chamber, discharging the battery pack at a standard rate C/3 until the battery pack is completely discharged, and recording an actual discharge capacity of the battery pack; and
separately adjusting the temperature of the constant temperature chamber to 0°C, 20°C, 25°C, 30°C, and 40°C, repeating the foregoing steps, and calculating the function relationship between the temperature and the temperature correction factor by using a MATLAB polyfit algorithm based on actual discharge capacities at different temperature values.

Optionally, the charge/discharge cycle quantity correction factor in step (2) is determined based on a function relationship between a charge/discharge cycle quantity and the charge/discharge cycle quantity correction factor, and the function relationship between the charge/discharge cycle quantity and the charge/discharge cycle quantity correction factor is obtained by performing the following steps:

charging/discharging the battery pack at a charge/discharge current of 1 C in the normal temperature environment of 25°C, and recording an actual discharge capacity of the battery pack;
resting the battery pack, and cyclically performing the foregoing step for preset times; and
calculating a relationship between the charge/discharge cycle quantity and a discharge capacity by using a MATLAB polyfit algorithm, and determining the function relationship between the charge/discharge cycle quantity and the charge/discharge cycle quantity correction factor based on the relationship between the charge/discharge cycle quantity and the discharge capacity.

Optionally, in step (3), correction is performed based on the SOC before resting; the initial value $SOC_0$ is corrected based on a voltage value of a largest battery cell when the SOC before resting is greater than 70%; the initial value $SOC_0$ is corrected based on a voltage value of a smallest battery cell when the SOC is less than 40%; and in another case, the initial value $SOC_0$ is corrected based on an average voltage value of battery cells.

Optionally, step (4) includes:

determining whether the SOC of the battery pack is greater than 90% or less than 10%;

if the SOC of the battery pack is greater than 90% or less than 10%, performing terminal correction, recording a battery voltage $U_1$ and a current $I_x$ in this case, and recording currents that are of two discharge curves of a BMS at different rates and that are closest to $I_x$ as $I_1$ and $I_2$, where $I_1 < I_x < I_2$;

recording a remaining power corresponding to $I_1$ and a remaining power corresponding to $I_2$ as $SOC_1$ and $SOC_2$ at a terminal voltage $U_1$, and making

$$\frac{SOC_2 - SOC_x}{SOC_2 - SOC_1} = \frac{I_2 - I_x}{I_2 - I_1};$$

and deriving corrected $SOC_x$ at the curent $I_x$ from the foregoing formula, where

$$SOC_x = SOC_2 - \frac{I_2 - I_x}{I_2 - I_1}(SOC_2 - SOC_1).$$

According to another aspect of this application, a battery SOC estimation apparatus with terminal correction is provided. The apparatus is configured to:

obtain an initial value $SOC_0$ of a battery capacity based on an open-circuit voltage method when the battery pack does not operate and is in a resting state;

update in real time, during operating of the battery pack, a SOC of the battery pack based on preset correction factors affecting the battery capacity, where the correction factors include a charge/discharge current correction factor, a temperature correction factor, and a charge/discharge cycle quantity correction factor;

when the battery pack stops operating, correct the initial value $SOC_0$ of the battery capacity based on the open-circuit voltage method and the SOC before the battery pack stops operating; and

perform terminal correction on the SOC if the SOC of the battery pack is greater than 90% or less than 10%.

Optionally, the apparatus is further configured to:

obtain a correspondence diagram of an open-circuit voltage and the SOC of the battery pack that is determined in a curve fitting manner; and

obtain the open-circuit voltage of the battery pack based on the open-circuit voltage method, and determine, based on the correspondence diagram, the initial value $SOC_0$ of the battery capacity that corresponds to the open-circuit voltage of the battery pack, where

the correspondence diagram of the open-circuit voltage and the SOC of the battery pack is plotted by performing the following steps:

discharging the battery pack to a cut-off voltage at a constant current, and resting the battery pack until the battery pack is completely discharged;

charging the completely discharged battery pack at a constant current to 5% of a rated capacity, recording a terminal voltage of the battery pack in this case, and resting the battery pack for preset duration;

continuing to charge the battery pack at a constant current to 10% of the rated capacity, recording a terminal voltage of the battery pack in this case, and resting the battery pack for preset duration; and

continuing to charge the battery pack at a constant current until the battery pack is fully charged, and plotting the correspondence diagram of the open-circuit voltage and the SOC of the battery pack in the curve fitting manner after the battery pack is fully charged, where 5% of the rated capacity is charged each time.

Optionally, the apparatus is further configured to:

obtain the initial value $SOC_0$ of the battery capacity based on the open-circuit voltage method again and update the initial value $SOC_0$ when a resting time of the battery pack exceeds a specific value.

Optionally, a calculation formula for updating the SOC is:

$$SOC = SOC_0 - K_n \frac{1}{C} \eta K_t \int_0^t K_i i \, dt$$

where $SOC_0$ is an initial state of charge of the battery pack, C is a total capacity of the battery pack, $\eta$ is charge/discharge

efficiency of the battery pack, i is a charge/discharge current, $K_n$ is the charge/discharge cycle quantity correction factor, $K_t$ is the temperature correction factor, and $K_i$ is the charge/discharge current correction factor.

Optionally, the charge/discharge current correction factor is determined based on a function relationship between the charge/discharge current correction factor and a discharge current, and the function relationship between the charge/discharge current correction factor and the discharge current is obtained by performing the following steps:

charging the battery pack to a fully charged state in a normal temperature environment of 25°C;
discharging the fully charged battery pack at a constant current, and recording a battery discharge capacity in this case;
changing the discharge current with a temperature remaining unchanged to discharge the fully charged battery pack, and recording a battery discharge capacity in this case; and
repeating the foregoing steps to obtain a relationship between the discharge current and an actual discharge capacity, and performing curve fitting by using MATLAB based on the relationship between the discharge current and the actual discharge capacity to obtain a function relationship between a discharge current correction factor and the discharge current.

Optionally, the temperature correction factor is determined based on a function relationship between a temperature and the temperature correction factor, and the function relationship between the temperature and the temperature correction factor is obtained by performing the following steps:

setting a constant temperature chamber to -20°C, charging the battery pack to a fully charged state, placing the battery pack in the constant temperature chamber, resting the battery pack until a temperature of the battery pack is consistent with a temperature of the constant temperature chamber, discharging the battery pack at a standard rate C/3 until the battery pack is completely discharged, and recording an actual discharge capacity of the battery pack; and
separately adjusting the temperature of the constant temperature chamber to 0°C, 20°C, 25°C, 30°C, and 40°C, repeating the foregoing steps, and calculating the function relationship between the temperature and the temperature correction factor by using a MATLAB polyfit algorithm based on actual discharge capacities at different temperature values.

Optionally, the charge/discharge cycle quantity correction factor is determined based on a function relationship between a charge/discharge cycle quantity and the charge/discharge cycle quantity correction factor, and the function relationship between the charge/discharge cycle quantity and the charge/discharge cycle quantity correction factor is obtained by performing the following steps:

charging/discharging the battery pack at a charge/discharge current of 1 C in the normal temperature environment of 25°C, and recording an actual discharge capacity of the battery pack;
resting the battery pack, and cyclically performing the foregoing step for preset times; and
calculating a relationship between the charge/discharge cycle quantity and a discharge capacity by using a MATLAB polyfit algorithm, and determining the function relationship between the charge/discharge cycle quantity and the charge/discharge cycle quantity correction factor based on the relationship between the charge/discharge cycle quantity and the discharge capacity.

Optionally, the apparatus is further configured to:
perform correction based on the SOC before resting; correct the initial value $SOC_0$ based on a voltage value of a largest battery cell when the SOC before resting is greater than 70%; correct the initial value $SOC_0$ based on a voltage value of a smallest battery cell when the SOC is less than 40%; and in another case, correct the initial value $SOC_0$ based on an average voltage value of battery cells.

Optionally, the apparatus is further configured to:

determine whether the SOC of the battery pack is greater than 90% or less than 10%;
if the SOC of the battery pack is greater than 90% or less than 10%, perform terminal correction, record a battery voltage $U_1$ and a current $I_x$ in this case, and record currents that are of two discharge curves of a BMS at different rates and that are closest to $I_x$ as $I_1$ and $I_2$, where $I_1 < I_x < I_2$;
record a remaining power corresponding to $I_1$ and a remaining power corresponding to $I_2$ as $SOC_1$ and $SOC_2$ at a terminal voltage $U_1$, and make

$$\frac{SOC_2 - SOC_x}{SOC_2 - SOC_1} = \frac{I_2 - I_x}{I_2 - I_1};$$

and

derive corrected $SOC_x$ at the current $I_x$ from the foregoing formula, where

$$SOC_x = SOC_2 - \frac{I_2 - I_x}{I_2 - I_1}(SOC_2 - SOC_1).$$

According to still another aspect of this application, a storage medium is provided, having a computer program stored thereon. The foregoing battery SOC estimation method with terminal correction is implemented when the program is executed by a processor.

According to yet another aspect of this application, a computer device is provided, including a storage medium, a processor, and a computer program stored in the storage medium and capable of running on the processor. The battery SOC estimation method with terminal correction is implemented when the processor executes the program.

According to the foregoing technical solutions and the battery SOC estimation method and apparatus with terminal correction, the storage medium, and the computer device provided in this application, the SOC of the battery pack is updated in real time by using an improved ampere-hour integration method, the correction factors affecting the battery capacity are analyzed, calculation processes of the correction factors are provided, SOC correction is performed based on a voltage value of a battery cell when a correction condition is met, and terminal correction is performed on the SOC at the end of charging/discharging based on charge/discharge cases of the battery pack at different rates, thereby improving accuracy and stability of battery SOC estimation.

The foregoing description is merely an overview of the technical solutions in this application. To understand the technical means in this application more clearly, the technical means may be implemented based on the content of the specification. In addition, to make the foregoing and other objectives, features, and advantages of this application clearer and easier to understand, specific implementations of this application are enumerated below.

## BRIEF DESCRIPTION OF DRAWINGS

To describe the technical solutions in the embodiments of this application or in the conventional technology more clearly, the following briefly describes the accompanying drawings required for describing the embodiments or the conventional technology. Clearly, the accompanying drawings in the following description show merely some embodiments of this application, and a person of ordinary skill in the art may still derive other accompanying drawings from these accompanying drawings without creative efforts.

FIG. 1 is a schematic flowchart of a battery SOC estimation method with terminal correction according to an embodiment of this application;

FIG. 2 is a schematic diagram of a relationship between a discharge current and an actual discharge capacity according to an embodiment of this application;

FIG. 3 is a schematic diagram of a relationship between a temperature and a discharge capacity according to an embodiment of this application;

FIG. 4 is a schematic diagram of a relationship between a charge/discharge cycle quantity and a discharge capacity according to an embodiment of this application; and

FIG. 5 is a schematic diagram of an apparatus structure of a computer device according to an embodiment of this application.

## DESCRIPTION OF EMBODIMENTS

The following clearly and completely describes the technical solutions in embodiments of this application with reference to the accompanying drawings in the embodiments of this application. Clearly, the described embodiments are merely some rather than all of the embodiments of this application. All other embodiments obtained by a person of ordinary skill in the art based on the embodiments of this application without creative efforts shall fall within the protection scope of this application.

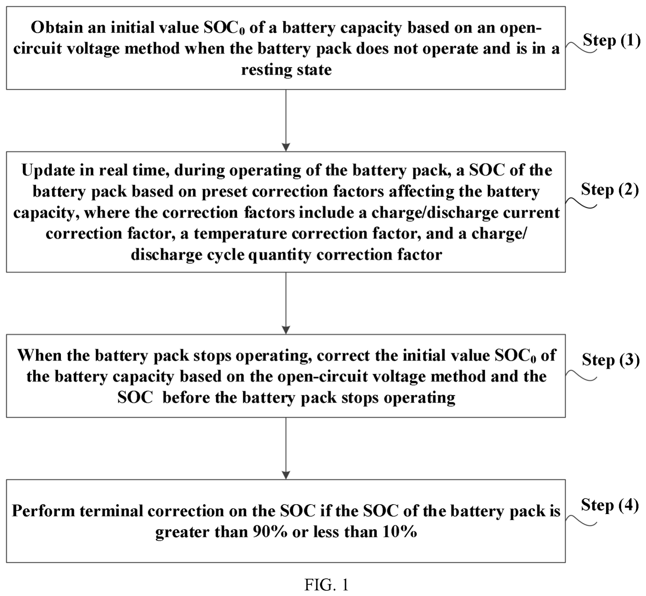

This application provides a battery SOC estimation method with terminal correction in this embodiment. As shown in FIG. 1, the method includes the following steps.

Step (1): Obtain an initial value $SOC_0$ of a battery capacity based on an open-circuit voltage method when the battery pack does not operate and is in a resting state.

In this embodiment of this application, because $SOC_0$ needs to be periodically updated due to charging/discharging of the battery pack, the initial value $SOC_0$ of the battery capacity needs to be obtained based on the open-circuit voltage method.

Optionally, step (1) includes: obtaining a correspondence diagram of an open-circuit voltage and the SOC of the battery pack that is determined in a curve fitting manner; and obtaining the open-circuit voltage of the battery pack based on the open-circuit voltage method, and determining, based on the correspondence diagram, the initial value $SOC_0$ of the battery capacity that corresponds to the open-circuit voltage of the battery pack, where the correspondence diagram of the open-circuit voltage and the SOC of the battery pack is plotted by performing the following steps: discharging the battery pack to a cut-off voltage at a constant current, and resting the battery pack until the battery pack is completely discharged; charging the completely discharged battery pack at a constant current to 5% of a rated capacity, recording a terminal voltage of the battery pack in this case, and resting the battery pack for preset duration; continuing to charge the battery pack at a constant current to 10% of the rated capacity, recording a terminal voltage of the battery pack in this case, and resting the battery pack for preset duration; and continuing to charge the battery pack at a constant current until the battery pack is fully charged, and plotting the correspondence diagram of the open-circuit voltage and the SOC of the battery pack in the curve fitting manner after the battery pack is fully charged, where 5% of the rated capacity is charged each time.

Optionally, the method further includes: obtaining the initial value $SOC_0$ of the battery capacity based on the open-circuit voltage method again and updating the initial value $SOC_0$ when a resting time of the battery pack exceeds a specific value.

In this embodiment, a specific process of calculating and updating $SOC_0$ includes the following steps: (1) First, the battery pack is discharged to the cut-off voltage at a constant current, and rests to ensure complete discharging. (2) The completely discharged battery pack is charged at a constant current to the rated capacity of 5%, where it is required to ensure high precision of an output current during charging; and the terminal voltage of the battery pack is recorded in this case and the battery pack rests for a period of time. (3) The battery pack is continuously charged at a constant current to the rated capacity of 10%, the terminal voltage of the battery pack is recorded in this case, and the battery pack rests for a period of time. (4) The foregoing steps are cyclically performed until the battery pack is fully charged, and the correspondence diagram of the open-circuit voltage and the SOC of the battery pack is obtained in the curve fitting manner. (5) $SOC_0$ is updated when a resting time of the battery pack exceeds a specific value.

Step (2): Update in real time, during operating of the battery pack, a SOC of the battery pack based on preset correction factors affecting the battery capacity, where the correction factors include a charge/discharge current correction factor, a temperature correction factor, and a charge/discharge cycle quantity correction factor.

In this embodiment of this application, the SOC of the battery pack needs to be updated in real time based on an improved ampere-hour integration method. The correction factors required for the improved ampere-hour integration method include the charge/discharge current correction factor, the temperature correction factor, and the charge/discharge cycle quantity correction factor.

Optionally, a calculation formula for updating the SOC in step (2) is:

$$SOC = SOC_0 - K_n \frac{1}{C} \eta K_t \int_0^t K_i\, i\, dt$$

where $SOC_0$ is an initial state of charge of the battery pack, C is a total capacity of the battery pack, $\eta$ is charge/discharge efficiency of the battery pack, i is a charge/discharge current, $K_n$ is the charge/discharge cycle quantity correction factor, $K_t$ is the temperature correction factor, and $K_i$ is the charge/discharge current correction factor.

In this embodiment, in a conventional ampere-hour integration method, a state of charge of a battery pack is calculated through integration of a current and a time in a charge/discharge process of the battery pack. That is:

$$SOC = SOC_0 - \frac{1}{C} \eta \int_0^t i\, dt$$

$SOC_0$ is an initial state of charge of the battery pack, C is a total capacity of the battery pack, $\eta$ is charge/discharge efficiency of the battery pack, and i is a charge/discharge current. This method requires a high rated capacity and high sampling current precision of the battery pack, and discharge efficiencies of the battery pack are different at different temperatures. Therefore, an improved ampere-hour integration method is provided for SOC estimation. The charge/discharge current correction factor, the temperature correction factor, and the charge/discharge cycle quantity correction factor are added to the improved ampere-hour integration method. That is,

$$SOC = SOC_0 - K_n \frac{1}{C} \eta K_t \int_0^t K_i i \, dt$$

$K_n$ is the charge/discharge cycle quantity correction factor, $K_t$ is the temperature correction factor, and $K_i$ is the charge/discharge current correction factor.

Optionally, the charge/discharge current correction factor in step (2) is determined based on a function relationship between the charge/discharge current correction factor and a discharge current, and the function relationship between the charge/discharge current correction factor and the discharge current is obtained by performing the following steps: charging the battery pack to a fully charged state in a normal temperature environment of 25°C; discharging the fully charged battery pack at a constant current, and recording a battery discharge capacity in this case; changing the discharge current with a temperature remaining unchanged to discharge the fully charged battery pack, and recording a battery discharge capacity in this case; and repeating the foregoing steps to obtain a relationship between the discharge current and an actual discharge capacity, and performing curve fitting by using MATLAB based on the relationship between the discharge current and the actual discharge capacity to obtain a function relationship between a discharge current correction factor and the discharge current.

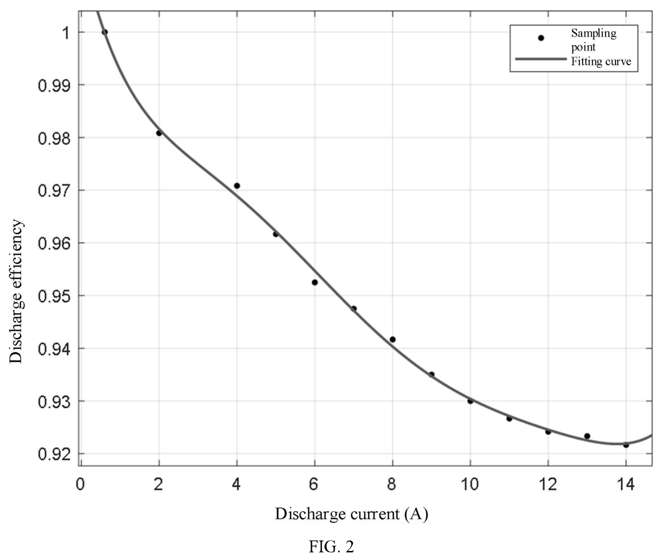

In this embodiment, battery discharge capacities are different in different current cases. Therefore, a current needs to be corrected during SOC estimation to correct the battery capacity. Calculation of a current correction factor thereof includes the following several steps: (1) The battery pack is charged to the fully charged state in the normal temperature environment of 25°C. (2) The fully charged battery pack is discharged at a constant current, and the battery discharge capacity in this case is recorded. (3) The discharge current is changed with the temperature remaining unchanged to discharge the fully charged battery pack, and the battery discharge capacity in this case is recorded. (4) The foregoing steps are repeated to obtain the relationship between the discharge current and the actual discharge capacity, as shown in FIG. 2; and a function relationship between the current correction factor and the discharge current is obtained by performing curve fitting by using MATLAB, where a specific function relationship is as follows: $K_i(I) = (2.727e^{-7} * I^6 - 1.358e^{-5} * I^5 + 0.000263 * I^4 - 0.002466 I^3 + 0.01156 I^2 - 0.03206 I + 1.015)/12$, and I is the discharge current.

Optionally, the temperature correction factor in step (2) is determined based on a function relationship between a temperature and the temperature correction factor, and the function relationship between the temperature and the temperature correction factor is obtained by performing the following steps: setting a constant temperature chamber to -20°C, charging the battery pack to a fully charged state, placing the battery pack in the constant temperature chamber, resting the battery pack until a temperature of the battery pack is consistent with a temperature of the constant temperature chamber, discharging the battery pack at a standard rate C/3 until the battery pack is completely discharged, and recording an actual discharge capacity of the battery pack; and separately adjusting the temperature of the constant temperature chamber to 0°C, 20°C, 25°C, 30°C, and 40°C, repeating the foregoing steps, and calculating the function relationship between the temperature and the temperature correction factor by using a MATLAB polyfit algorithm based on actual discharge capacities at different temperature values.

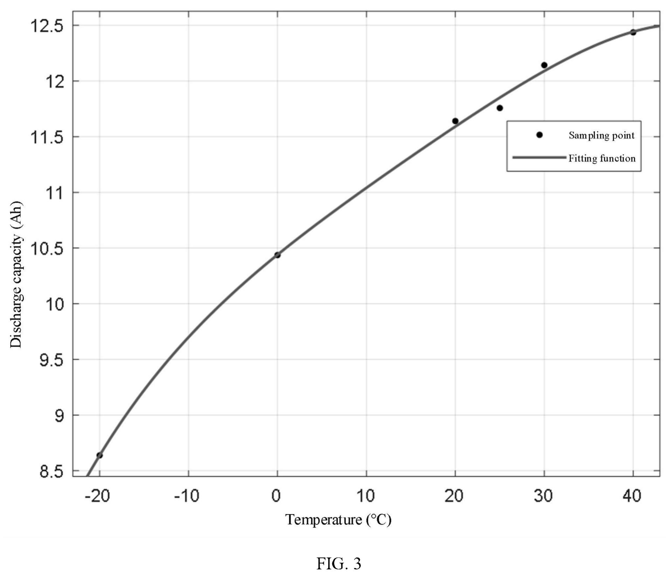

In this embodiment, the actual discharge capacities of the battery pack are different at different temperatures because chemicals inside a lithium battery are affected by a temperature. When an environment temperature is low, activity of the chemicals inside the lithium battery is low, and the actual discharge capacity of the battery pack decreases. The activity of the chemicals inside the lithium battery increases with the temperature, and the actual discharge capacity of the battery pack also increases. The actual discharge capacities of the battery pack at different temperatures may be obtained by using performing an experiment, and calculation of the temperature correction factor thereof includes the following several steps: (1) The battery pack is first charged to the fully charged state. (2) The battery pack is placed in the constant temperature chamber and the temperature of the constant temperature chamber is set to -20°C, and the battery pack rests for a period of time, so that the temperature of the battery pack is consistent with that of the constant temperature chamber. (3) The battery pack is discharged at the standard rate C/3 until the battery pack is completely discharged, and the actual discharge capacity of the battery pack is recorded. (4) The temperature of the constant temperature chamber is separately adjusted to 0°C, 20°C, 25°C, 30°C, and 40°C, and steps (2) and (3) are repeated. (5) A relationship between a temperature and the discharge capacity is calculated by using a MATLAB polyfit algorithm, as shown in FIG. 3, where a specific function relationship is $K_t(T) = (-3.824e^{-7} * T^4 + 2.261e^{-5} * T^3 - 0.000661 * T^2 + 0.06481 * T + 10.44)/12$, and T is an environment temperature.

Optionally, the charge/discharge cycle quantity correction factor in step (2) is determined based on a function relationship between a charge/discharge cycle quantity and the charge/discharge cycle quantity correction factor, and the function relationship between the charge/discharge cycle quantity and the charge/discharge cycle quantity correction factor is obtained by performing the following steps: charging/discharging the battery pack at a charge/discharge current of 1 C in the normal temperature environment of 25°C, and recording an actual discharge capacity of the battery pack; resting the battery pack, and cyclically performing the foregoing step for preset times; and calculating a relationship between the charge/discharge cycle quantity and a discharge capacity by using a MATLAB polyfit algorithm, and determining the function relationship between the charge/discharge cycle quantity and the charge/discharge cycle quantity correction factor based on the relationship between the charge/discharge cycle quantity and the discharge capacity.

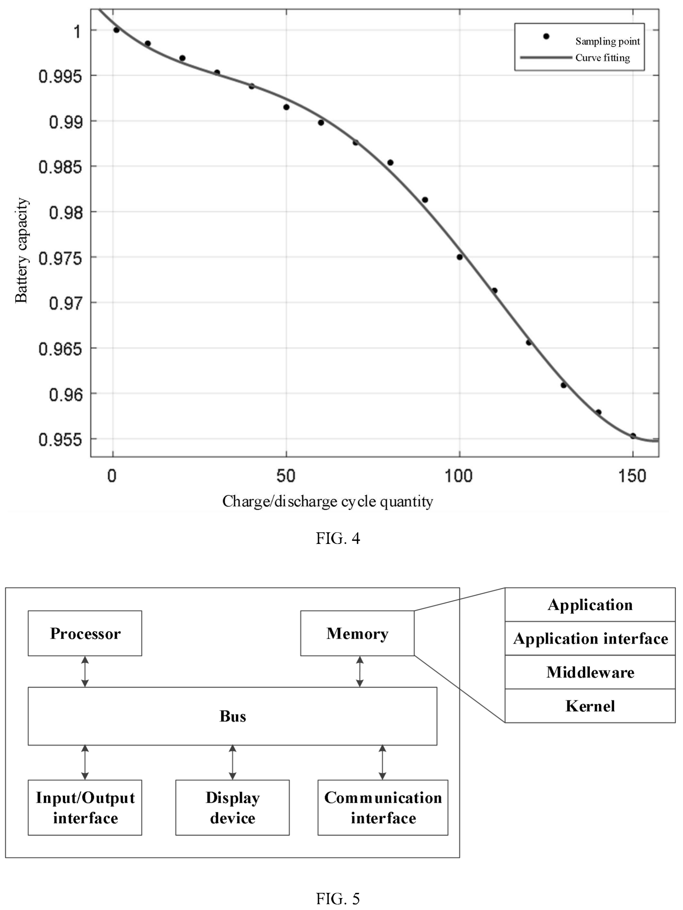

In this embodiment, capacity fading occurs during use of the lithium battery, and capacity fading occurs after each charge/discharge cycle. A relationship between the charge/discharge cycle quantity and an actual discharge capacity may be obtained by performing an experiment, and the charge/discharge cycle quantity correction factor is calculated. Calculation of the charge/discharge cycle quantity correction factor includes the following several steps: (1) The battery pack is charged/discharged at the charge/discharge current of 1 C in the normal temperature environment of 25°C, and the actual discharge capacity of the battery pack is recorded. (2) The battery pack rests and the foregoing step is cyclically performed for 150 times. (3) The relationship between the charge/discharge cycle quantity and the discharge capacity is calculated by using the MATLAB polyfit algorithm, as shown in FIG. 4, where a specific function relationship is $K_n(N) = 3.704e^{-10} * N^4 +- 1.056e^{-7} * N^3 + 7.72e^{-6} * N^2 - 0.0003367 * N + 1.001$, and N is the charge/discharge cycle quantity.

Step (3): When the battery pack stops operating, correct the initial value $SOC_0$ of the battery capacity based on the open-circuit voltage method and the SOC before the battery pack stops operating.

In this embodiment of this application, when the battery pack stops operating, the initial SOC of the battery capacity is corrected based on the open-circuit voltage method, and is stored in a single chip microcomputer.

Optionally, in step (3), correction is performed based on the SOC before resting; the initial value $SOC_0$ is corrected based on a voltage value of a largest battery cell when the SOC before resting is greater than 70%; the initial value $SOC_0$ is corrected based on a voltage value of a smallest battery cell when the SOC is less than 40%; and in another case, the initial value $SOC_0$ is corrected based on an average voltage value of battery cells.

In this embodiment, a two-dimensional array is established in software according to the correspondence diagram of the open-circuit voltage and the SOC of the battery pack in step (1). A correspondence thereof is written into code, so that the initial SOC of the battery capacity is corrected in a static mode through lookup. When the initial SOC is corrected, correction is performed based on the SOC before resting. When the SOC is greater than 70%, the SOC is corrected based on the voltage value of the largest battery cell; when the SOC is less than 40%, the SOC is corrected based on the voltage value of the smallest battery cell; and in another case, the SOC is corrected based on the average voltage value of the battery cells.

Step (4): Perform terminal correction on the SOC if the SOC of the battery pack is greater than 90% or less than 10%.

In this embodiment of this application, when the SOC of the battery pack is greater than 90% or less than 10%, terminal correction is performed on the SOC according to charge/discharge cases of the battery pack at different rates. When the SOC of the battery pack is greater than 90% or less than 10%, a discharge curve thereof has a non-linear characteristic. In this case, a voltage change of the battery pack is relatively small. When the SOC of the battery pack is less than 10%, because the voltage change of the battery pack is small, a conventional remaining power estimation method may estimate a remaining power as 0% too early, causing the battery pack to enter a protection state too early, and resulting in a limitation on available energy of the battery pack. When the SOC of the battery pack is greater than 90%, because the voltage change of the battery pack is still small, the conventional remaining power estimation method may estimate the remaining power as 100% too early, causing the battery pack to enter an over-charged state too early, and resulting in waste of rechargeable energy of the battery pack. Therefore, terminal correction needs to be performed to improve accuracy of remaining power estimation.

Optionally, step (4) includes: determining whether the SOC of the battery pack is greater than 90% or less than 10%; if the SOC of the battery pack is greater than 90% or less than 10%, performing terminal correction, recording a battery voltage $U_1$ and a current $I_x$ in this case, and recording currents that are of two discharge curves of a BMS at different rates and that are closest to $I_x$ as $I_1$ and $I_2$, where $I_1 < I_x < I_2$; and recording a remaining power corresponding to $I_1$ and a remaining power corresponding to $I_2$ as $SOC_1$ and $SOC_2$ at a terminal voltage $U_1$, and making

$$\frac{SOC_2 - SOC_x}{SOC_2 - SOC_1} = \frac{I_2 - I_x}{I_2 - I_1};$$

and
deriving corrected $SOC_0$ at the current $I_x$ from the foregoing formula, where

$$SOC_x = SOC_2 - \frac{I_2 - I_x}{I_2 - I_1}(SOC_2 - SOC_1).$$

In this embodiment, a calculation process of terminal correction includes the following several steps: (1) Whether the SOC of the battery pack is greater than 90% or less than 10% is determined, and terminal correction is performed if the SOC of the battery pack is greater than 90% or less than 10%. (2) If the battery pack is in a terminal correction state, the

battery voltage $U_1$ and the current$I_x$ in this case are recorded, the currents that are of the two discharge curves of the BMS at different rates and that are closest to $I_x$ are recorded as $I_1$ and $I_2$, where $I_1 < I_x < I_2$. (3) The remaining power corresponding to $I_1$ and the remaining power corresponding to $I_2$ are recorded as $SOC_1$ and $SOC_2$ at the terminal voltage

$U_1$, and $\dfrac{SOC_2 - SOC_x}{SOC_2 - SOC_1} = \dfrac{I_2 - I_x}{I_2 - I_1}$ . (4) The corrected $SOC_x$ at the current $I_x$ may be derived through the third step, that is,

$$SOC_x = SOC_2 - \frac{I_2 - I_x}{I_2 - I_1}(SOC_2 - SOC_1) .$$

According to the technical solutions in this embodiment, the SOC of the battery pack is updated in real time by using the improved ampere-hour integration method, the correction factors affecting the battery capacity are analyzed, calculation processes of the correction factors are provided, SOC correction is performed based on a voltage value of a battery cell when a correction condition is met, and terminal correction is performed on the SOC at the end of charging/discharging based on charge/discharge cases of the battery pack at different rates, thereby improving accuracy and stability of battery SOC estimation.

Further, as a specific implementation of the method in FIG. 1, an embodiment of this application provides a battery SOC estimation apparatus with terminal correction. The apparatus is configured to:

> obtain an initial value $SOC_0$ of a battery capacity based on an open-circuit voltage method when the battery pack does not operate and is in a resting state;
> update in real time, during operating of the battery pack, a SOC of the battery pack based on preset correction factors affecting the battery capacity, where the correction factors include a charge/discharge current correction factor, a temperature correction factor, and a charge/discharge cycle quantity correction factor;
> when the battery pack stops operating, correct the initial value $SOC_0$ of the battery capacity based on the open-circuit voltage method and the SOC before the battery pack stops operating; and
> perform terminal correction on the SOC if the SOC of the battery pack is greater than 90% or less than 10%.

Optionally, the apparatus is further configured to:

> obtain a correspondence diagram of an open-circuit voltage and the SOC of the battery pack that is determined in a curve fitting manner; and
> obtain the open-circuit voltage of the battery pack based on the open-circuit voltage method, and determine, based on the correspondence diagram, the initial value $SOC_0$ of the battery capacity that corresponds to the open-circuit voltage of the battery pack, where
> the correspondence diagram of the open-circuit voltage and the SOC of the battery pack is plotted by performing the following steps:

>> discharging the battery pack to a cut-off voltage at a constant current, and resting the battery pack until the battery pack is completely discharged;
>> charging the completely discharged battery pack at a constant current to 5% of a rated capacity, recording a terminal voltage of the battery pack in this case, and resting the battery pack for preset duration;
>> continuing to charge the battery pack at a constant current to 10% of the rated capacity, recording a terminal voltage of the battery pack in this case, and resting the battery pack for preset duration; and
>> continuing to charge the battery pack at a constant current until the battery pack is fully charged, and plotting the correspondence diagram of the open-circuit voltage and the SOC of the battery pack in the curve fitting manner after the battery pack is fully charged, where 5% of the rated capacity is charged each time.

Optionally, the apparatus is further configured to:
obtain the initial value $SOC_0$ of the battery capacity based on the open-circuit voltage method again and update the initial value $SOC_0$ when a resting time of the battery pack exceeds a specific value.

Optionally, a calculation formula for updating the SOC is:

$$SOC = SOC_0 - K_n \frac{1}{C} \eta K_t \int_0^t K_i i \, dt$$

where $SOC_0$ is an initial state of charge of the battery pack, C is a total capacity of the battery pack, $\eta$ is charge/discharge efficiency of the battery pack, i is a charge/discharge current, $K_n$ is the charge/discharge cycle quantity correction factor, $K_t$

is the temperature correction factor, and $K_i$ is the charge/discharge current correction factor.

Optionally, the charge/discharge current correction factor is determined based on a function relationship between the charge/discharge current correction factor and a discharge current, and the function relationship between the charge/discharge current correction factor and the discharge current is obtained by performing the following steps:

charging the battery pack to a fully charged state in a normal temperature environment of 25°C;
discharging the fully charged battery pack at a constant current, and recording a battery discharge capacity in this case;
changing the discharge current with a temperature remaining unchanged to discharge the fully charged battery pack, and recording a battery discharge capacity in this case; and
repeating the foregoing steps to obtain a relationship between the discharge current and an actual discharge capacity, and performing curve fitting by using MATLAB based on the relationship between the discharge current and the actual discharge capacity to obtain a function relationship between a discharge current correction factor and the discharge current.

Optionally, the temperature correction factor is determined based on a function relationship between a temperature and the temperature correction factor, and the function relationship between the temperature and the temperature correction factor is obtained by performing the following steps:

setting a constant temperature chamber to -20°C, charging the battery pack to a fully charged state, placing the battery pack in the constant temperature chamber, resting the battery pack until a temperature of the battery pack is consistent with a temperature of the constant temperature chamber, discharging the battery pack at a standard rate C/3 until the battery pack is completely discharged, and recording an actual discharge capacity of the battery pack; and
separately adjusting the temperature of the constant temperature chamber to 0°C, 20°C, 25°C, 30°C, and 40°C, repeating the foregoing steps, and calculating the function relationship between the temperature and the temperature correction factor by using a MATLAB polyfit algorithm based on actual discharge capacities at different temperature values.

Optionally, the charge/discharge cycle quantity correction factor is determined based on a function relationship between a charge/discharge cycle quantity and the charge/discharge cycle quantity correction factor, and the function relationship between the charge/discharge cycle quantity and the charge/discharge cycle quantity correction factor is obtained by performing the following steps:

charging/discharging the battery pack at a charge/discharge current of 1 C in the normal temperature environment of 25°C, and recording an actual discharge capacity of the battery pack;
resting the battery pack, and cyclically performing the foregoing step for preset times; and
calculating a relationship between the charge/discharge cycle quantity and a discharge capacity by using a MATLAB polyfit algorithm, and determining the function relationship between the charge/discharge cycle quantity and the charge/discharge cycle quantity correction factor based on the relationship between the charge/discharge cycle quantity and the discharge capacity.

Optionally, the apparatus is further configured to:
perform correction based on the SOC before resting; correct the initial value $SOC_0$ based on a voltage value of a largest battery cell when the SOC before resting is greater than 70%; correct the initial value $SOC_0$ based on a voltage value of a smallest battery cell when the SOC is less than 40%; and in another case, correct the initial value $SOC_0$ based on an average voltage value of battery cells.

Optionally, the apparatus is further configured to:

determine whether the SOC of the battery pack is greater than 90% or less than 10%;
if the SOC of the battery pack is greater than 90% or less than 10%, perform terminal correction, record a battery voltage $U_1$ and a current $I_x$ in this case, and record currents that are of two discharge curves of a BMS at different rates and that are closest to $I_x$ as $I_1$ and $I_2$, where $I_1 < I_x < I_2$;
record a remaining power corresponding to $I_1$ and a remaining power corresponding to $I_2$ as $SOC_1$ and $SOC_2$ at a terminal voltage $U_1$, and make

$$\frac{SOC_2 - SOC_x}{SOC_2 - SOC_1} = \frac{I_2 - I_x}{I_2 - I_1};$$

and

derive corrected $SOC_x$ at the current $I_x$ from the foregoing formula, where

$$SOC_x = SOC_2 - \frac{I_2 - I_x}{I_2 - I_1}(SOC_2 - SOC_1).$$

It should be noted that, for other corresponding descriptions of functional units related to the battery SOC estimation apparatus with terminal correction provided in this embodiment of this application, refer to corresponding descriptions in the method in FIG. 1 and FIG. 2. Details are not described herein again.

An embodiment of this application further provides a computer device, which may be specifically a personal computer, a server, a network device, or the like. As shown in FIG. 5, the computer device includes a bus, a processor, a memory, and a communication interface, and may further include an input/output interface and a display device. The processor of the computer device is configured to provide a computing and control capability. The memory of the computer device includes a non-volatile storage medium and a memory. The non-volatile storage medium stores an operating system, a computer program, and a database. The memory provides an environment for running of the operating system and the computer program in the non-volatile storage medium. The database of the computer device is configured to store location information. The network interface of the computer device is configured to connect to and communicate with an external terminal via a network. Steps in the method embodiment are implemented when the computer program is executed by the processor.

A person skilled in the art may understand that the structure shown in FIG. 5 is merely a block diagram of a part of a structure related to the solutions of this application, and constitutes no limitation on the computer device to which the solutions of this application are applied. Specifically, the computer device may include more or fewer components than those shown in the figure, or combine some components, or have different component arrangements.

An embodiment provides a computer-readable storage medium. The computer-readable storage medium may be a non-volatile or volatile storage medium, and stores a computer program. Steps in the method embodiment are implemented when the computer program is executed by a processor.

An embodiment provides a computer program product, including a computer program, where steps in the method embodiment are implemented when the computer program is executed by a processor.

It should be noted that user information (including but not limited to user equipment information and user personal information) and data (including but not limited to data used for analysis, stored data, and displayed data) involved in this application are all information and data that are authorized by the user or that are fully authorized by each party.

A person of ordinary skill in the art may understand that all or some of the processes of the method in the foregoing embodiments may be implemented by a computer program instructing related hardware. The computer program may be stored in a non-volatile computer-readable storage medium. When the computer program is executed, the processes in the foregoing method embodiment may be included. Any reference to the memory, the database, or another medium used in the embodiments provided in this application may include at least one of a non-volatile memory or a volatile memory. The non-volatile memory may include a read-only memory (Read-Only Memory, ROM), a magnetic tape, a floppy disk, a flash memory, an optical memory, a high-density embedded non-volatile memory, a resistive random access memory (ReRAM), a magnetoresistive random access memory (Magnetoresistive Random Access Memory, MRAM), a ferroelectric random access memory (Ferroelectric Random Access Memory, FRAM), a phase change memory (Phase Change Memory, PCM), a graphene memory, or the like. The volatile memory may include a random access memory (random access memory, RAM), an external cache, or the like. As an illustration and not a limitation, the RAM may be in a plurality of forms, such as a static random access memory (Static Random Access Memory, SRAM) or a dynamic random access memory (Dynamic Random Access Memory, DRAM). The database involved in the embodiments provided in this application may include at least one of a relational database or a non-relational database. The non-relational database may include a block chain-based distributed database or the like, and is not limited thereto. The processor in the embodiments provided in this application may be a general purpose processor, a central processing unit, a graphics processing unit, a digital signal processor, a programmable logic device, a quantum computing-based data processing logic device, or the like, and is not limited thereto.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in this specification.

The foregoing embodiments represent only several implementations of this application, and are described in a relatively specific and detailed way, but should not be construed as limitations on the patent scope of this application. It should be noted that a person of ordinary skill in the art can further make several variations and improvements without departing from the concept of this application, and these variations and improvements shall fall within the protection scope of this application. Therefore, the protection scope of this application shall be subject to the appended claims.

**Claims**

1. A battery SOC estimation method with terminal correction, **characterized by** comprising the following steps:

   step (1): obtaining an initial value $SOC_0$ of a battery capacity based on an open-circuit voltage method when the battery pack does not operate and is in a resting state;
   step (2): updating in real time, during operating of the battery pack, a SOC of the battery pack based on preset correction factors affecting the battery capacity, wherein the correction factors comprise a charge/discharge current correction factor, a temperature correction factor, and a charge/discharge cycle quantity correction factor;
   step (3): when the battery pack stops operating, correcting the initial value $SOC_0$ of the battery capacity based on the open-circuit voltage method and the SOC before the battery pack stops operating; and
   step (4): performing terminal correction on the SOC if the SOC of the battery pack is greater than 90% or less than 10%.

2. The battery SOC estimation method with terminal correction according to claim 1, **characterized in that** step (1) comprises:

   obtaining a correspondence diagram of an open-circuit voltage and the SOC of the battery pack that is determined in a curve fitting manner; and
   obtaining the open-circuit voltage of the battery pack based on the open-circuit voltage method, and determining, based on the correspondence diagram, the initial value $SOC_0$ of the battery capacity that corresponds to the open-circuit voltage of the battery pack, wherein
   the correspondence diagram of the open-circuit voltage and the SOC of the battery pack is plotted by performing the following steps:

   discharging the battery pack to a cut-off voltage at a constant current, and resting the battery pack until the battery pack is completely discharged;
   charging the completely discharged battery pack at a constant current to 5% of a rated capacity, recording a terminal voltage of the battery pack in this case, and resting the battery pack for preset duration;
   continuing to charge the battery pack at a constant current to 10% of the rated capacity, recording a terminal voltage of the battery pack in this case, and resting the battery pack for preset duration; and
   continuing to charge the battery pack at a constant current until the battery pack is fully charged, and plotting the correspondence diagram of the open-circuit voltage and the SOC of the battery pack in the curve fitting manner after the battery pack is fully charged, wherein 5% of the rated capacity is charged each time.

3. The battery SOC estimation method with terminal correction according to claim 2, **characterized in that** the method further comprises:
   obtaining the initial value $SOC_0$ of the battery capacity based on the open-circuit voltage method again and updating the initial value $SOC_0$ when a resting time of the battery pack exceeds a specific value.

4. The battery SOC estimation method with terminal correction according to claim 1, **characterized in that** a calculation formula for updating the SOC in step (2) is:

$$SOC = SOC_0 - K_n \frac{1}{C} \eta K_t \int_0^t K_i i \, dt$$

   wherein $SOC_0$ is an initial state of charge of the battery pack, C is a total capacity of the battery pack, $\eta$ is charge/discharge efficiency of the battery pack, i is a charge/discharge current, $K_n$ is the charge/discharge cycle quantity correction factor, $K_t$ is the temperature correction factor, and $K_i$ is the charge/discharge current correction factor.

5. The battery SOC estimation method with terminal correction according to claim 4, **characterized in that** the charge/discharge current correction factor in step (2) is determined based on a function relationship between the charge/discharge current correction factor and a discharge current, and the function relationship between the charge/discharge current correction factor and the discharge current is obtained by performing the following steps:

   charging the battery pack to a fully charged state in a normal temperature environment of 25°C;

discharging the fully charged battery pack at a constant current, and recording a battery discharge capacity in this case;

changing the discharge current with a temperature remaining unchanged to discharge the fully charged battery pack, and recording a battery discharge capacity in this case; and

repeating the foregoing steps to obtain a relationship between the discharge current and an actual discharge capacity, and performing curve fitting by using MATLAB based on the relationship between the discharge current and the actual discharge capacity to obtain a function relationship between a discharge current correction factor and the discharge current.

6. The battery SOC estimation method with terminal correction according to claim 4, **characterized in that** the temperature correction factor in step (2) is determined based on a function relationship between a temperature and the temperature correction factor, and the function relationship between the temperature and the temperature correction factor is obtained by performing the following steps:

setting a constant temperature chamber to -20°C, charging the battery pack to a fully charged state, placing the battery pack in the constant temperature chamber, resting the battery pack until a temperature of the battery pack is consistent with a temperature of the constant temperature chamber, discharging the battery pack at a standard rate C/3 until the battery pack is completely discharged, and recording an actual discharge capacity of the battery pack; and

separately adjusting the temperature of the constant temperature chamber to 0°C, 20°C, 25°C, 30°C, and 40°C, repeating the foregoing steps, and calculating the function relationship between the temperature and the temperature correction factor by using a MATLAB polyfit algorithm based on actual discharge capacities at different temperature values.

7. The improved ampere-hour integration method with terminal correction for battery SOC estimation according to claim 5, **characterized in that** the charge/discharge cycle quantity correction factor in step (2) is determined based on a function relationship between a charge/discharge cycle quantity and the charge/discharge cycle quantity correction factor, and the function relationship between the charge/discharge cycle quantity and the charge/discharge cycle quantity correction factor is obtained by performing the following steps:

charging/discharging the battery pack at a charge/discharge current of 1 C in the normal temperature environment of 25°C, and recording an actual discharge capacity of the battery pack;

resting the battery pack, and cyclically performing the foregoing step for preset times; and

calculating a relationship between the charge/discharge cycle quantity and a discharge capacity by using a MATLAB polyfit algorithm, and determining the function relationship between the charge/discharge cycle quantity and the charge/discharge cycle quantity correction factor based on the relationship between the charge/discharge cycle quantity and the discharge capacity.

8. The improved ampere-hour integration method with terminal correction for battery SOC estimation according to claim 1, **characterized in that** in step (3), correction is performed based on the SOC before resting; the initial value $SOC_0$ is corrected based on a voltage value of a largest battery cell when the SOC before resting is greater than 70%; the initial value $SOC_0$ is corrected based on a voltage value of a smallest battery cell when the SOC is less than 40%; and in another case, the initial value $SOC_0$ is corrected based on an average voltage value of battery cells.

9. The improved ampere-hour integration method with terminal correction for battery SOC estimation according to claim 1, **characterized in that** step (4) comprises:

determining whether the SOC of the battery pack is greater than 90% or less than 10%;

if the SOC of the battery pack is greater than 90% or less than 10%, performing terminal correction, recording a battery voltage $U_1$ and a current $I_x$ in this case, and recording currents that are of two discharge curves of a BMS at different rates and that are closest to $I_x$ as $I_1$ and $I_2$, wherein $I_1 < I_x < I_2$;

recording a remaining power corresponding to $I_1$ and a remaining power corresponding to $I_2$ as $SOC_1$ and $SOC_2$ at a terminal voltage $U_1$, and making

$$\frac{SOC_2 - SOC_x}{SOC_2 - SOC_1} = \frac{I_2 - I_x}{I_2 - I_1};$$

and

deriving corrected $SOC_x$ at the current $I_x$ from the foregoing formula, wherein

$$SOC_x = SOC_2 - \frac{I_2 - I_x}{I_2 - I_1}(SOC_2 - SOC_1).$$

**10.** A battery SOC estimation apparatus with terminal correction, **characterized in that** the apparatus is configured to:

obtain an initial value $SOC_0$ of a battery capacity based on an open-circuit voltage method when the battery pack does not operate and is in a resting state;

update in real time, during operating of the battery pack, a SOC of the battery pack based on preset correction factors affecting the battery capacity, wherein the correction factors comprise a charge/discharge current correction factor, a temperature correction factor, and a charge/discharge cycle quantity correction factor;

when the battery pack stops operating, correct the initial value $SOC_0$ of the battery capacity based on the open-circuit voltage method and the SOC before the battery pack stops operating; and

perform terminal correction on the SOC if the SOC of the battery pack is greater than 90% or less than 10%.

Obtain an initial value $SOC_0$ of a battery capacity based on an open-circuit voltage method when the battery pack does not operate and is in a resting state     Step (1)

Update in real time, during operating of the battery pack, a SOC of the battery pack based on preset correction factors affecting the battery capacity, where the correction factors include a charge/discharge current correction factor, a temperature correction factor, and a charge/discharge cycle quantity correction factor     Step (2)

When the battery pack stops operating, correct the initial value $SOC_0$ of the battery capacity based on the open-circuit voltage method and the SOC before the battery pack stops operating     Step (3)

Perform terminal correction on the SOC if the SOC of the battery pack is greater than 90% or less than 10%     Step (4)

FIG. 1

FIG. 2

FIG. 3

FIG. 4

FIG. 5

## INTERNATIONAL SEARCH REPORT

| International application No. |
|---|
| **PCT/CN2024/088005** |

| **A. CLASSIFICATION OF SUBJECT MATTER** |
|---|
| G01R31/382(2019.01)i;  G01R31/387(2019.01)i;  G01R31/367(2019.01)i |

According to International Patent Classification (IPC) or to both national classification and IPC

| **B. FIELDS SEARCHED** |
|---|
| Minimum documentation searched (classification system followed by classification symbols) |
| IPC:G01R31 |

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 电池, 荷电状态, SOC, 末端, 非线性, 平台区, 平坦, 分段, 静置, 停止, 熄火, 暂停, 开路电压, OCV, 初始, 修正, 校正, 校准, 补偿, 因子, 因数, 系数, 电流, 温度, 循环; VEN, USTXT, WOTXT, EPTXT: battery, state of charge, SOC, tail, non-linear, platform, stewing, standing, stage, period, stop, bloom, extinction, open circuit voltage, OCV, initial, correct, amend, compensate, factor, coefficient, current, temperature, circulate

| **C. DOCUMENTS CONSIDERED TO BE RELEVANT** |
|---|

| Category* | Citation of document, with indication, where appropriate, of the relevant passages | Relevant to claim No. |
|---|---|---|
| PX | CN 117233623 A (SUZHOU QIANCHENG NEW ENERGY TECHNOLOGY CO., LTD.) 15 December 2023 (2023-12-15)<br>claims 1-10 | 1-10 |
| Y | CN 110133510 A (SHAANXI UNIVERSITY OF SCIENCE AND TECHNOLOGY) 16 August 2019 (2019-08-16)<br>description, paragraphs 32-36 | 1-10 |
| Y | CN 110380481 A (NO.48 RESEARCH INSTITUTE OF CETC) 25 October 2019 (2019-10-25)<br>description, paragraphs 36-50 | 1-10 |
| Y | CN 107091994 A (ANHUI RNTEC TECHNOLOGY CO., LTD.) 25 August 2017 (2017-08-25)<br>description, paragraphs 40-63 | 1-10 |

☑ Further documents are listed in the continuation of Box C.    ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **07 June 2024** | **09 July 2024** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**EP 4 718 095 A1**

**INTERNATIONAL SEARCH REPORT**

International application No.

**PCT/CN2024/088005**

**C. DOCUMENTS CONSIDERED TO BE RELEVANT**

| Category* | Citation of document, with indication, where appropriate, of the relevant passages | Relevant to claim No. |
|---|---|---|
| Y | 贺林 等 (HE, Lin et al.). "一种分阶段锂离子电池荷电状态估计算法 (SOC Estimation of Lithium-ion Battery in Stages)" 电力电子技术 (Power Electronics), Vol. 54, No. 02, 20 February 2020 (2020-02-20), pages 8-11 ISSN: 1000-100X, page 9, left column, paragraph 1-page 10, right column, paragraph 2 | 1-10 |
| Y | CN 108062086 A (CHINA AVIATION LITHIUM BATTERY RESEARCH INSTITUTE CO., LTD. et al.) 22 May 2018 (2018-05-22) description, paragraphs 36-62 | 1-10 |
| Y | CN 107202963 A (ANHUI RNTEC TECHNOLOGY CO., LTD.) 26 September 2017 (2017-09-26) description, paragraphs 60-75 | 1-10 |
| A | CN 116298895 A (CHERY AUTOMOBILE CO., LTD.) 23 June 2023 (2023-06-23) entire document | 1-10 |
| A | CN 116520162 A (XIANGTAN UNIVERSITY) 01 August 2023 (2023-08-01) entire document | 1-10 |
| A | JP 2022149608 A (SUBARU CORP.) 07 October 2022 (2022-10-07) entire document | 1-10 |
| A | 罗勇 等 (LUO, Yong et al.). "基于容量修正的安时积分SOC估算方法研究 (Study on Battery SOC Estimation by Ampere-hour Integral Method with Capacity Correction)" 汽车工程 (Automotive Engineering), Vol. 42, No. 05, 25 May 2020 (2020-05-25), pages 681-687 ISSN: 1000-680X, entire document | 1-10 |
| A | 陈曦 等 (CHEN, Xi et al.). "一种改进的安时——开路电压估算SOC的方法 (Non-official translation: An Improved Method of Estimating SOC Using Ampere-Hour-Open Circuit Voltage)" 北京汽车 (Beijing Automotive Engineering), No. 04, 25 August 2016 (2016-08-25), pages 33-37 ISSN: 1002-4581, entire document | 1-10 |

**INTERNATIONAL SEARCH REPORT**
Information on patent family members

International application No.

**PCT/CN2024/088005**

| Patent document cited in search report | | | Publication date (day/month/year) | Patent family member(s) | | | Publication date (day/month/year) |
|---|---|---|---|---|---|---|---|
| CN | 117233623 | A | 15 December 2023 | None | | | |
| CN | 110133510 | A | 16 August 2019 | CN | 110133510 | B | 13 August 2021 |
| CN | 110380481 | A | 25 October 2019 | None | | | |
| CN | 107091994 | A | 25 August 2017 | CN | 107091994 | B | 13 August 2019 |
| CN | 108062086 | A | 22 May 2018 | CN | 108062086 | B | 04 June 2019 |
| CN | 107202963 | A | 26 September 2017 | CN | 107202963 | B | 13 August 2019 |
| CN | 116298895 | A | 23 June 2023 | None | | | |
| CN | 116520162 | A | 01 August 2023 | None | | | |
| JP | 2022149608 | A | 07 October 2022 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311256358